# FASCICULE DE BREVET EUROPEEN

(11) **EP 3 122 811 B1**
(45) Date de publication et mention de la délivrance du brevet: **16.05.2018**
(21) Numéro de dépôt: 15717566.2
(22) Date de dépôt: 26.03.2015
(51) Int. Cl.: C08K 3/22, H05K 1/16, H05K 9/00

(54) **COMPOSITES POLYMÈRE - CÉRAMIQUE**
POLYMER-KERAMIK KOMPOSIT
POLYMER-CERAMIC COMPOSITE

(30) Priorité: 28.03.2014 FR 1452720
(43) Date de publication de la demande: 01.02.2017
(73) Titulaire: Saint-Gobain Centre De Recherches Et D'etudes Europeen, 92400 Courbevoie (FR)
(72) Inventeur: RAFFY, Stéphane, F-84300 Cavaillon (FR)
(74) Mandataire: Saint-Gobain Recherche
(86) Numéro de dépôt international: PCT/FR2015/050783
(87) Numéro de publication internationale: WO 2015/145084

(56) Documents cités:
- EP-A1- 0 443 229
- WO-A1-97/20324
- WO-A1-97/42639
- WO-A1-98/26431
- WO-A2-03/005444
- US-A1- 2004 072 074
- US-A1- 2008 128 961
- US-A1- 2009 073 636
- US-A1- 2009 101 873
- US-A1- 2010 105 806
- US-A1- 2012 171 569

## Description

L'invention se rapporte à des composites polymère-céramique notamment pour des applications électroniques comportant des grains de sous oxydes de titane ou de sous oxydes de titanate de baryum ou de strontium. Par sous-oxydes de titane on entend classiquement des oxydes de titane de formulation générale TiOₓ dans lesquels x est compris entre 1 et 2, bornes exclues, en particulier les phases dites de Magnéli. Par sous oxydes de titanate de baryum/strontium on entend classiquement des oxydes de formulation générale Ba₍₁₋ₘ₎SrₘTiO_{y} dans lesquels y est compris entre 1,5 et 3, bornes exclues et m est compris entre 0 et 1, bornes incluses.

Le brevet EP 047 595 B1 (ou son équivalent US 4,422,917) propose des matériaux constitués de sous-oxyde de type TiOₓ avec x compris entre 1,55 et 1,95, pour la réalisation d'électrodes. Les matériaux sont synthétisés à partir de poudre de TiO₂ en mélange avec un composé réducteur du type Ti, TiN, TiSi, C, TiO ou Ti₂O₃, à des températures comprises entre 1150 et 1450°C suivant la nature du composé réducteur.

Le brevet EP 572 559 B1 décrit, pour cette même application, l'utilisation des sous-oxydes de titane entièrement constitués de phases de Magnéli répondant à la composition TiₙO₂ₙ₋₁, avec n supérieur à 4. Le brevet décrit un procédé d'obtention de tels matériaux incluant une première étape sensiblement identique à celle décrite dans EP 047 595 B1, suivie d'une étape supplémentaire de recuit à une température comprise entre 1100 et 1300°C, en présence d'hydrogène, pour éliminer tous les oxydes inférieurs de titane.

La demande de brevet internationale WO2009/024776 décrit des matériaux similaires, constitués essentiellement d'un mélange des phases cristallines dites de Magnéli Ti₄O₇, Ti₅O₉ et Ti₆O₁₁. Il est indiqué qu'une telle constitution permet un meilleur compromis entre la conductivité électrique des particules de sous oxydes de titane et leur résistance à la corrosion, la phase Ti₄O₇ étant décrite comme la plus avantageuse pour obtenir les plus fortes conductivités. La méthode d'obtention de telles particules est décrite comme identique à celle décrite dans le brevet US 4,422,917 et consiste en une réduction par l'hydrogène d'une poudre de TiO₂, pendant 8 heures et à une température de 1180°C.

Les composites polymère-céramique selon la présente invention trouvent particulièrement leur application dans le domaine particulier des composants électroniques :
Les systèmes électroniques actuels comportent des composants actifs et des composants passifs. Ces derniers sont les résistors, les inductances et les condensateurs ; leur nombre ne cesse de croître, en même temps que leurs fonctionnalités se diversifient : par exemple, le ratio entre les composants passifs et les composants actifs dans un téléphone portable est supérieur à 20. Actuellement, la plupart des composants actifs sont montés à la surface des circuits électroniques sous forme discrète, ce qui limite la miniaturisation des circuits, et peut poser des problèmes de fiabilité du fait de la quantité de soudures nécessaires. Pour ces raisons, les composants passifs « intégrés » aux cartes électroniques présentent un intérêt croissant, et notamment les « condensateurs intégrés » (embedded capacitors en anglais), du fait de la très grande variété des fonctions qu'ils peuvent assurer : découplage de signal, suppression ou réduction du bruit, filtrage, etc... Les condensateurs intégrés sont généralement constitués d'un composite polymère-céramique laminé entre deux plaques ou films conducteurs : le polymère peut être une résine Epoxy ou du PTFE par exemple ; la charge céramique peut être du titanate de baryum BaTiO₃ ; les électrodes conductrices sont souvent en cuivre. La recherche très active dans ce domaine montre qu'il existe un besoin important d'augmenter la permittivité diélectrique de ces composites polymère-céramique, afin d'augmenter la capacité des « condensateurs intégrés ».

La demande de brevet WO2010/048297 décrit ainsi des composites polymère-céramique pour composants électroniques tels que des condensateurs. Il s'agit de composites dans lesquels la charge céramique peut être constituée de BaTiO₃ et/ou (Ba,Sr)TiO₃ et/ou TiO₂.

Par ailleurs, la complexité croissante des appareils électroniques, leur densité et leur vitesse de travail toujours plus importante, ont fortement augmenté le risque d'interférences électromagnétiques qui représentent un danger pour le fonctionnement correct des outils électroniques, pour la qualité des communications. Différents types de protection se sont donc développés, afin d'isoler les composants électroniques des ondes produites par les appareillages voisins. On distingue traditionnellement trois phénomènes permettant d'atténuer l'onde électromagnétique atteignant un système d'écrantage : la réflexion, l'absorption et les réflexions internes multiples. L'atténuation totale de l'amplitude de l'onde, exprimée en décibels, est ainsi la somme de ces trois composantes.

Les premiers écrans étaient métalliques et réfléchissaient efficacement les ondes ; mais le poids d'un écran métallique constitue un inconvénient souvent rédhibitoire. Des composites polymères-charges conductrices sont ensuite apparus comme élément de blindage ou de protection contre les ondes, permettant notamment de limiter les interférences électromagnétiques, les charges conductrices pouvant par exemple être des fibres métalliques. Cependant, ces charges métalliques utilisées pour réfléchir les ondes, présentent une faible résistance à la corrosion et à l'oxydation et une densité élevée qui limitent leur emploi. US 2009/073636 décrit des composites polymère-céramique qui présentent de bonnes propriétés mécaniques et une constante diélectrique élevée. Le composé inorganique diélectrique comprend un titanate de strontium (pas de sous-oxydes) (§ 26 et exemples). Le brevet US 7,815,820 décrit des composites polymère - céramique comme élément de de protection contre les ondes permettant l'atténuation d'ondes électromagnétiques. Il s'agit de composites dans lesquels la charge céramique peut être constituée de BaTiO₃ et/ou SrTiO₃ et/ou (Ba,Sr)TiO₃.

Il existe encore un besoin pour des polymères-charges permettant d'atténuer plus efficacement les ondes électromagnétiques. L'atténuation par absorption peut être améliorée avec un matériau présentant une permittivité diélectrique plus élevée.

Il existe donc plusieurs domaines dans lesquels on rencontre un besoin pour des composites polymères-charges présentant une permittivité diélectrique améliorée. L'objet de la présente invention vise à répondre à ce besoin.

L'invention se rapporte selon un premier aspect à un élément pour l'électronique comprenant ou constitué par un composite polymère-céramique comportant des grains de sous oxydes de titane de formulation générale TiOₓ dans lesquels x est compris entre 1,00 et 1,99, bornes incluses, et/ou de sous oxydes de titanate de baryum et/ou de strontium de formulation générale Ba₍₁₋ₘ₎SrₘTiO_{y} dans lesquels y est compris entre 1,50 et 2,99, bornes incluses, et m est compris entre 0 et 1, bornes incluses.

Plus particulièrement, l'invention se rapporte à des composites polymère-céramique constitués d'une matrice de polymère dans laquelle est dispersée une charge céramique notamment pour une utilisation dans le domaine de l'électronique.

L'invention se rapporte également à un composite polymère-céramique comportant des grains de sous oxydes de titanate de baryum et/ou de strontium de formulation générale Ba₍₁₋ₘ₎SrₘTiO_{y} dans lesquels y est compris entre 1,50 et 2,99, bornes incluses, et m est compris entre 0 et 1, bornes incluses.

Dans l'élément ou dans le composite selon l'invention :
La matrice polymère peut représenter plus de 30% en volume du composite, voire plus de 40 % en volume, voire plus de 50% en volume. La matrice polymère peut représenter jusqu'à 80% du volume du composite. La matrice polymère représente de préférence moins de 70% en volume du composite, voire moins de 60 % en volume.

La charge (c'est-à-dire la partie) céramique peut représenter au total plus de 10% en volume du composite, voire plus de 20 % en volume, voire plus de 30% en volume. La charge céramique peut représenter jusqu'à 70% en volume du composite. Elle peut représenter de préférence moins de 60 % en volume, voire moins de 50% en volume, ou même moins de 40% en volume.

La matrice polymère peut être constituée par exemple de résine du type époxy, polyfluorure de vinylidène (PVDF), polytétrafluoroéthylène (PTFE), polyimides, polyamides, acrylates, polyphénylène éther, polyphénylène oxyde, benzocyclobutène, bismaléimide, ester de cyanate, polyester ou de leurs mélanges.

Selon un premier mode de réalisation possible, la résine est choisie parmi les résines thermodurcissables.

Selon un second mode de réalisation possible, la résine est choisie parmi les résines thermoplastiques.

La charge céramique peut comporter ou être constituée de des grains de sous oxydes de titane de formulation générale TiOₓ dans lesquels x est supérieur à 1,40, voire supérieur à 1,60, voire supérieur à 1,70 et/ou dans lesquels x est inférieur à 1,99, voire inférieur à 1,95, voire inférieur à 1,90.

Selon un mode de réalisation les grains de sous oxydes de titane représentent plus de 10% en volume, voire plus de 20% en volume, voire plus de 30% en volume du composite polymère-céramique.

En particulier, lesdits sous-oxydes de titane sont de préférence principalement des phases TiₙO₂ₙ₋₁ dans lesquelles n est compris entre 4 et 9, bornes incluses, c'est-à-dire Ti₄O₇, Ti₅O₉, Ti₆O₁₁, Ti₇O₁₃, Ti₈O₁₅ ou Ti₉O₁₇, lesdites phases représentant de préférence, au total, plus de 80%, voire 85% ou même 90% du poids des grains. En particulier, selon un mode avantageux, les phases Ti₅O₉ et/ou Ti₆O₁₁ peuvent représenter, au total, plus de 60% du poids des grains, de préférence plus 70% du poids des grains, et de manière très préférée plus de 80% du poids des grains.

La charge céramique peut alternativement ou en complément comporter ou être constituée de grains de sous oxydes de titanate de baryum et/ou de strontium. Ces grains présentent une formulation générale Ba₍₁₋ₘ₎ SrₘTiO_{y} dans laquelle, de préférence :
- y est supérieur à 1,70, voire supérieur à 2,00, voire supérieur à 2,25, voire supérieur à 2,50 et/ou y est inférieur à 2,95, voire inférieur à 2,90 et/ou
- m est inférieur à 0,9, voire inférieur à 0,70, voire inférieur à 0,5, voire inférieur à 0,3, voire inférieur à 0,1.

Selon un mode préféré, m est compris entre 0 et 0,3.

Selon un mode de réalisation les grains de sous oxydes de titanate de baryum et/ou de strontium représentent plus de 10% en volume, voire plus de 20% en volume, voire plus de 30% en volume du composite polymère-céramique.

Selon un mode de réalisation de l'invention, les grains de sous oxydes de titane et les grains de sous oxydes de titanate de baryum/strontium représentent ensemble plus de 10% en volume, voire plus de 20% en volume, voire plus de 30% en volume, voire plus de 40% en volume du composite polymère-céramique. Les grains de sous oxydes de titane et les grains de sous oxydes de titanate de baryum/strontium représentent ensemble de préférence moins de 70% en volume dudit composite, de préférence moins de 60 % en volume, voire moins de 50% en volume, ou même moins de 40% en volume.

Les différentes phases constituant les grains et leurs proportions peuvent être déterminés selon les techniques bien connues dans le domaine, en particulier par diffraction des rayons X. On observe que la phase Ba₍₁₋ₘ₎SrₘTiO_{y} se présente sous une forme cristalline au moins partiellement hexagonale alors que Ba₍₁₋ₘ₎SrₘTiO₃ se présente sous une forme cristalline cubique ou tétragonale.

La charge céramique dans le composite peut cependant comprendre d'autres espèces que les sous-oxydes de titane et/ou de titanate de baryum/strontium, en particulier la silice (SiO₂), ou bien d'autres éléments, présents essentiellement sous forme oxyde ou en solution solide avec le ou les sous-oxyde(s) de titane et/ou de titanate, notamment Al, Cr, Zr, Y, La, Nb, Ta, Fe, Co, Ni les alcalins ou les alcalino-terreux du type Ca, Na, K, Li. Sur la base des oxydes simples correspondants, la quantité sommée totale desdits éléments présents est de préférence inférieure à 30% en poids du composite polymère-céramique, par exemple inférieure à 20%, voire 10%, voire 5%, voire inférieure à 4%, ou même inférieure à 3% en poids du composite polymère-céramique.

Selon l'invention, à contrario, le polymère et les sous-oxydes de titane représentent normalement plus de 70% du poids total du composite, et notamment plus de 80%, plus de 90% ou même plus de 95%, voire plus de 96% ou même plus de 97% du poids du composite.

Selon un mode de réalisation préféré, la charge céramique est constituée à plus de 80% en poids de grains de sous oxydes de titane de formulation générale TiOₓ et/ou de grains de sous oxydes de titanate de baryum/strontium de formulation générale Ba₍₁₋ₘ₎SrₘTiO_{y}. De préférence, ces grains constituent plus de 85% en poids, voire plus de 90 % en poids, voire plus de 95% en poids, voire plus de 99% en poids de la charge céramique.

Selon un mode possible, la charge minérale dans ledit composite est constituée essentiellement de grains de sous-oxydes de titane.

Selon un autre mode, la charge minérale dans ledit composite est essentiellement constituée de grains de sous oxydes de titanate de baryum et/ou de strontium de formulation générale Ba₍₁₋ₘ₎SrₘTiO_{y}.

Selon un mode de réalisation possible, les grains de la charge céramique sont obtenus par réaction à l'état solide, c'est-à-dire par frittage de réactifs précurseurs, sans fusion. L'état réduit est obtenu soit en réalisant le frittage réactif en milieu réducteur (par exemple sous pression partielle d'hydrogène), soit en ajoutant un réducteur (par exemple une source de carbone comme le coke) aux réactifs initiaux et en réalisant le frittage réactif sous atmosphère neutre (par exemple sous argon), soit en réalisant le frittage réactif sous atmosphère oxydante puis en post-traitant les grains sous atmosphère réductrice, soit encore en réalisant le frittage réactif sous atmosphère oxydante puis en ajoutant un élément réducteur comme le carbone aux grains ainsi obtenus et en calcinant sous atmosphère neutre (par exemple sous argon).

Selon un autre mode de réalisation, la charge céramique comprend des grains fondus.

Par grains fondus, on entend des grains obtenus par un procédé de fabrication comprenant les étapes suivantes :
a) la fusion, dans des conditions réductrices, d'un mélange initial (ou charge initiale) comprenant des particules de dioxyde de titane, éventuellement d'oxyde de baryum, éventuellement d'oxyde de strontium, ou leurs précurseurs à une température supérieure à 1500°C, de préférence à une température supérieure à 1600°C, voire supérieure à 1700°C,
b) le refroidissement du mélange fondu jusqu'à sa solidification,
c) le broyage de la masse solidifiée pour l'obtention de grains fondus du ou des sous-oxydes.

Selon des modes préférés de réalisation du procédé :
Le mélange initial comprend du coke, utilisé comme agent réducteur.

Le mélange initial comprend entre 1 et 25% poids de coke, rapporté au poids total du mélange, de préférence entre 10 et 18% poids de coke. La fusion est réalisée sous air. On peut également réaliser la fusion sans ajout de coke, puis calciner les grains fondus sous atmosphère réductrice, ou bien les mélanger à un réducteur et les calciner sous atmosphère neutre.

Les oxydes de titane, de baryum et de strontium ou leurs précurseurs représentent plus de 90% de la masse minérale totale présente dans le mélange initial et de préférence représente la totalité de la masse minérale présente dans le mélange initial.

Lors de l'étape a), on utilise de préférence un four à arcs électriques, mais tous les fours connus sont envisageables, comme un four à induction ou un four à plasma, pourvu qu'ils permettent de faire fondre complètement le mélange ou la charge initiale. Selon une variante, la fusion peut s'opérer dans une torche à plasma. Dans ce cas, l'utilisation de coke n'est pas indispensable dans le mélange initial, la réduction pouvant être obtenue par réglage de l'atmosphère du plasma. Les grains fondus obtenus après l'étape c) peuvent également être fondus de nouveau dans une torche à plasma.

A l'étape c), la masse solidifiée est broyée, selon des techniques conventionnelles, jusqu'à obtenir la taille des grains propre à l'application envisagée. Par exemple, le broyage peut être poursuivi jusqu'à l'obtention de grains de taille millimétrique, par exemple de l'ordre de 0,1 à 5 millimètres, voire micrométrique, par exemple de l'ordre de 0,1 à 50 microns.

De préférence les grains fondus comprennent au total plus de 92%, voire plus de 94%, ou encore plus de 95% de sous-oxyde(s) de titane et/ou de sous oxydes de titanate de baryum/strontium.

Les grains fondus peuvent cependant comprendre d'autres phases, en particulier de la silice (SiO₂), ou bien d'autres éléments, présents essentiellement sous forme oxyde ou en solution solide avec le ou les sous-oxyde(s) de titane, notamment Al, Cr, Zr, Y, La, Nb, Ta, Fe, Co, Ni les alcalins ou les alcalino-terreux du type Ca, Na, K, Li. Sur la base des oxydes simples correspondants, la quantité sommée totale desdits éléments présents est de préférence inférieure à 10% poids de la masse totale des grains, par exemple inférieure à 5%, voire inférieure à 4%, ou même inférieure à 3% poids de la masse totale des grains fondus.

Les grains fondus peuvent en outre comprendre des traces de nitrures (nitrures, oxynitrures ou carbonitrures de titane)ou de carbures.

Selon un mode préféré, les grains fondus selon l'invention sont constitués uniquement desdits sous-oxydes de titane et/ou sous-oxydes de titanate, les autres phases n'étant présentes que sous la forme d'impuretés inévitables.

Selon un mode de réalisation, les grains fondus répondent essentiellement à une formulation globale moyenne TiOₓ, dans laquelle x est compris entre 1,50 et 1,95, et de préférence dans laquelle x est compris entre 1,75 et 1,85, de préférence encore entre 1,75 et 1,80.

En particulier, lesdits sous-oxydes de titane sont de préférence principalement des phases TiₙO₂ₙ₋₁ dans lesquelles n est compris entre 4 et 9, bornes incluses, c'est-à-dire Ti₄O₇, Ti₅O₉, Ti₆O₁₁, Ti₇O₁₃, Ti₈O₁₅ ou Ti₉O₁₇, lesdites phases représentant de préférence, au total, plus de 80%, voire 85% ou même 90% du poids des grains.

En particulier, selon un mode avantageux, les phases Ti₅O₉ et/ou Ti₆O₁₁ peuvent représenter, au total, plus de 60% du poids des grains, de préférence plus 70% du poids des grains, et de manière très préférée plus de 80% du poids des grains. De préférence selon un tel mode, les grains comprennent moins de 30% en poids de Ti₄O₇. De tels grains fondus présentent une résistivité électrique relativement basse et une bonne résistance à la corrosion.

Selon un autre mode de réalisation possible et alternatif, le composite polymère-céramique peut cependant également ne pas comprendre lesdits grains fondus constitués essentiellement de phases de sous-oxydes de titane répondant à la formulation TiₙO₂ₙ₋₁, dans lesquels lesdites phases sont principalement Ti₅O₉ ou Ti₆O₁₁ ou un mélange de ces deux phases, lesdites phases Ti₅O₉ et/ou Ti₆O₁₁ représentant, au total, plus de 60% du poids des grains, lesdits grains comprenant en outre moins de 30% en poids de Ti₄O₇.

Selon un mode de réalisation, la charge céramique est constituée à plus de 80% en poids de grains de sous oxydes de titane de formulation générale TiOₓ et/ou de grains de sous oxydes de titanate de baryum/strontium de formulation générale Ba₍₁₋ₘ₎SrₘTiO_{y}. De préférence, ces grains constituent plus de 85% en poids, voire plus de 90 % en poids, voire plus de 95% en poids, voire plus de 99% en poids de la charge céramique.

Avantageusement, la charge céramique présente une permittivité suffisante et supérieure à 100, voire supérieure à 500 et une résistivité limitée et inférieure à 1 Ω.cm.

Les composites polymère - céramique selon l'invention comprenant une telle charge céramique présentent ainsi une permittivité améliorée c'est-à-dire une permittivité supérieure à celle obtenue avec des composites de l'état de la technique ou bien une permittivité équivalente pour une teneur en charge céramique moindre.

Selon un mode de réalisation, utile en particulier pour l'atténuation des ondes électromagnétiques, le composite polymère - céramique comprend en outre jusqu'à 30% en volume de charges magnétiques, notamment céramiques (par exemple un oxyde de fer, notamment sous forme Fe₂O₃ ou Fe₃O₄) ou métalliques.

Selon un mode de réalisation, les grains de sous oxydes de titane et/ou de sous oxydes de titanate sont revêtus d'une couche permettant d'assurer une meilleure cohésion avec la matrice polymère et/ou une bonne isolation électrique. Cette couche peut par exemple être constituée de silice, de silicate, ou de silane. Cette couche peut par exemple être obtenue par une étape d'oxydation superficielle ou par une méthode de type « sol-gel ».

Les composites polymère - céramique de l'invention sont obtenus par :
- mélange de la ou des poudre (s) céramique constituant la charge céramique avec le ou les polymère(s) constituant la matrice polymère, ou avec un précurseur du polymère. Eventuellement, le mélange peut se faire dans un solvant permettant de mettre en solution une partie des précurseurs du polymère.
- mise en forme du mélange par exemple par extrusion, laminage, pressage, injection,
- optionnellement, traitement thermique.

Les composites polymère - céramique peuvent ainsi se présenter sous la forme de films minces (d'épaisseur généralement comprise entre 10 et 500 microns), en particulier pour les condensateurs intégrés. Ils peuvent également se présenter sous la forme de pièces de forme, en particulier pour l'atténuation des ondes électromagnétiques.

L'invention concerne également les produits comprenant des composites polymère-céramique selon l'invention. De tels produits sont notamment des éléments pour l'électronique, comme par exemple des condensateurs intégrés, des éléments de blindage ou de protection pour l'atténuation des ondes électromagnétiques ou tout autre composant électronique ou pour l'électronique dans lequel une permittivité suffisante est nécessaire.

Afin de ne pas alourdir inutilement la présente description, toutes les combinaisons possibles selon l'invention entre les différents modes tels qu'ils ont été décrits précédemment, ne sont pas reportées. Il est cependant bien entendu que toutes les combinaisons possibles des domaines et valeurs initiaux et/ou préférés précédemment décrits sont envisagées à l'heure du dépôt de la présente demande et doivent être considérées comme décrites par le demandeur dans le cadre de la présente description (notamment de deux, trois combinaisons ou plus).

Les exemples qui suivent, bien que non limitatif de la portée de la présente invention, en illustrent les avantages.

Dans un premier temps quatre poudres de charge céramique sont préparées :
- Préparation de grains fondus de sous oxydes de titanate de baryum puis broyage pour obtenir une poudre de diamètre médian d₅₀ égal à 1,55 µm (poudre P1) ;
- Préparation de grains fondus de sous oxydes de titanate de baryum puis broyage pour obtenir une poudre de diamètre médian d₅₀ égal à 1,42 µm (poudre P2) ;
- Préparation de grains fondus de sous oxydes de titane de formulation générale TiOₓ avec x = 1,78 puis broyage pour obtenir une poudre de diamètre médian d₅₀ égal à 1,35 µm (poudre P3).

On observe que les poudres P1 à P3 ont une couleur bleue très sombre témoignant de leur état réduit, sous-stoechiométrique.

On utilise comme référence (Réf.) une poudre de BaTiO₃ commercialisée par Sigma-Aldrich, de couleur blanche, présentant un diamètre médian d₅₀ de 0,93 µm.

La composition chimique et les phases cristallines présentes sont analysées à partir de la poudre de grains fondus. Les résultats sont reportés dans les tableaux 1 et 2 qui suivent.

Des composites polymère - céramique sont ensuite obtenus par :
- mélange respectivement des différentes poudres Ref., P1, P2, P3 (constituant la charge céramique) avec une résine acrylique ALTS fournie par la société ESCIL (constituant la matrice polymère), de manière à ce que la charge céramique représente 20% en volume du mélange composite final;
- mise en forme du mélange par pressage à chaud à 180°C, sous la forme d'échantillon de diamètre 25mm et d'épaisseur 5mm.

La permittivité des composites polymère-céramique ainsi obtenus est ensuite mesurée. Les résultats sont regroupés dans le tableau 3 qui suit.

Les protocoles expérimentaux utilisés pour la caractérisation de la composition et des propriétés des différents échantillons obtenus sont les suivants :
1°) La composition chimique globale des grains de sous oxydes de titanate de baryum/strontium (poudres P1 et P2) a été déterminée par fluorescence des rayons X. Les résultats obtenus, donnés en pourcentage en poids, sont regroupés dans le tableau 1 qui suit.
2°) La valeur « x » des grains dans la formulation générale TiOₓ (poudre P3) a été déterminée grâce à un essai consistant à mesurer la prise de masse d'un échantillon porté à 1000°C sous air qui va s'oxyder jusqu'à atteindre la stoechiométrie TiO₂. Le chauffage est poursuivi jusqu'à la stabilisation du poids de l'échantillon. La prise de masse finale, correspondant à la différence entre le composé stoechiométrique TiO₂ et la composition initiale, permet de calculer la valeur de x de la formule générale TiOₓ. La teneur en impuretés est déterminée par fluorescence des rayons X. On détermine ainsi que l'échantillon testé présente un taux d'impuretés total compris entre 1% et au maximum 4% en poids. Les résultats obtenus, donnés en pourcentage en poids, sont regroupés dans le tableau 2 qui suit.
3°) Les phases cristallines présentes dans les grains fondus ont été caractérisées par diffraction des rayons X. Les résultats obtenus sont regroupés dans les tableaux 1 et 2 qui suivent. Dans ces tableaux, PP indique une phase principale, PM indique la présence d'une moins une autre phase minoritaire, « ∼ » signifie que la ou les phase(s) est présente(s) sous forme de traces. On considère au sens de la présente invention qu'une phase est « principale » quand elle est la phase majoritaire et de préférence représente au moins 25%, voire au moins 35% du poids total des grains. On considère qu'une phase est « minoritaire » lorsqu'elle représente plus de 5% et moins de 25% du poids des grains, en particulier plus de 5% et moins de 25% du poids des grains. On considère qu'une phase est sous forme de « traces » quand elle représente moins de 1% du poids total des grains.
4°) La permittivité des échantillons est mesurée selon la norme ASTM D150 à 100 Hertz. Les résultats obtenus sont regroupés dans le tableau 3 qui suit.

**Tableau 1**

| | Ref. | P1 | P2 |
|---|---|---|---|
| BaO | 65,1 | 63,3 | 65,6 |
| SrO | < 0,1 | 0,4 | 0,4 |
| TiO₂ | 34,7 | 36 | 33,7 |
| Phases | BaTiO₃ sous forme tétragonale ou cubique (PP) | BaTiO_{y} sous forme hexagonale (PP) BaTiO_{y} sous forme tetragonale (∼) | BaTiO_{2,85} (PP) Ba₂TiO₄ (PM) BaTiO_{y} sous forme tetragonale (∼) |

**Tableau 2**

| | P3 |
|---|---|
| SiO₂ | 0,6 % |
| Al₂O₃ | <0,1 % |
| Fe₂O₃ | 0,2 % |
| ZrO₂ | 0,3 % |
| Nb₂O₅ | 0,2 % |
| x | 1,78 |
| Phases | Ti₅O₉ (PP) |
| | Ti₃O₅ (PM) |
| | Ti₄O₇ (PM) |
| | Ti₆O₁₁ (PM) |

**Tableau 3**

| | Ref. | P1 | P2 | P3 |
|---|---|---|---|---|
| Permittivité | 8,43 | 13,28 | 12,7 | 12,24 |

Les résultats reportés dans les tableaux qui précèdent montrent que les composites polymère-céramique selon l'invention présentent ainsi une permittivité sensiblement améliorée par rapport aux composites polymère-céramique utilisant une poudre céramique de référence.

## Revendications

1. Elément pour l'électronique comprenant ou constitué par un composite polymère-céramique comportant des grains de sous oxydes de titane de formulation générale TiOₓ dans laquelle x est compris entre 1,00 et 1,99, bornes incluses, et/ou des grains de sous oxydes de titanate de baryum et/ou de strontium de formulation générale Ba₍₁₋ₘ₎SrₘTiO_{y} dans laquelle y est compris entre 1,50 et 2,99, bornes incluses, et m est compris entre 0 et 1, bornes incluses.

2. Elément pour l'électronique selon la revendication précédente dans lequel le composite polymère-céramique comprend plus de 10% en volume de grains de sous oxydes de titane de formulation générale TiOₓ dans lesquels x est compris entre 1,50 et 1,99, bornes incluses.

3. Elément pour l'électronique selon l'une des revendications précédentes, dans lequel lesdits sous-oxydes de titane sont principalement des phases TiₙO₂ₙ₋₁ dans lesquelles n est compris entre 4 et 9, bornes incluses, c'est-à-dire Ti₄O₇, Ti₅O₉, Ti₆O₁₁, Ti₇O₁₃, Ti₈O₁₅ ou TigO₁₇, lesdites phases représentant, au total, plus de 80% du poids des grains.

4. Elément pour l'électronique selon l'une des revendications précédentes dans lequel le composite polymère-céramique comprend plus de 10% en volume de grains de sous oxydes de titanate de baryum/strontium de formulation générale Ba₍₁₋ₘ₎SrₘTiO_{y} dans lesquels y est compris entre 2,50 et 2,99, bornes incluses et m est compris entre 0 et 1, bornes incluses.

5. Elément pour l'électronique selon la revendication précédente, dans lequel m est compris entre 0 et 0,3, bornes incluses.

6. Elément pour l'électronique selon l'une des revendications précédentes, dans lequel le polymère représente de 30 à 80% en volume dudit composite polymère-céramique.

7. Elément pour l'électronique selon l'une des revendications précédentes, dans lequel le polymère du composite polymère-céramique est choisi dans le groupe constitué par les résines époxy, polyfluorure de vinylidène (PVDF), polytétrafluoroéthylène (PTFE), polyimides, polyamides, acrylates, polyphénylène éther, polyphénylène oxyde, benzocyclobutène, bismaléimide, ester de cyanate, polyester ou leurs mélanges.

8. Elément pour l'électronique selon l'une des revendications précédentes, dans laquelle le polymère du composite polymère-céramique est choisi parmi les résines thermodurcissables.

9. Elément pour l'électronique selon l'une des revendications précédentes, dans laquelle le polymère du composite polymère-céramique est choisi parmi les résines thermoplastiques.

10. Elément pour l'électronique selon l'une des revendications précédentes, dans lequel les grains de sous oxydes de titane et/ou les grains de sous oxydes de titanate de baryum/strontium représentent ensemble de 30 à 70% en volume dudit composite polymère-céramique.

11. Elément pour l'électronique selon l'une des revendications précédentes, dans lequel le polymère, les sous-oxydes de titane et les sous oxydes de titanate de baryum/strontium représentent ensemble plus de 70% du poids total du composite polymère-céramique et de préférence plus de 90% du poids du composite.

12. Elément pour l'électronique selon l'une des revendications précédentes, dans lequel la charge minérale dans ledit composite polymère-céramique est constituée essentiellement de grains de sous-oxydes de titane.

13. Elément pour l'électronique selon l'une des revendications précédentes, dans lequel la charge minérale dans ledit composite polymère-céramique est essentiellement constituée de grains de sous oxydes de titanate de baryum et/ou de strontium de formulation générale Ba₍₁₋ₘ₎ SrₘTiO_{y}.

14. Elément pour l'électronique selon l'une des revendications précédentes, dans lequel ledit composant est un condensateur, de préférence un condensateur intégré.

15. Elément pour l'électronique selon l'une des revendications 1 à 13, dans lequel ledit composant ledit élément est un écran d'atténuation des ondes électromagnétiques.

16. Composite polymère-céramique comportant des grains de sous oxydes de titanate de baryum et/ou de strontium de formulation générale Ba₍₁₋ₘ₎ SrₘTiO_{y}, dans laquelle y est compris entre 1,50 et 2,99, bornes incluses, et m est compris entre 0 et 1, bornes incluses.

17. Composite polymère-céramique selon la revendication précédente comprenant plus de 10% en volume de grains de sous oxydes de titanate de baryum/strontium de formulation générale Ba₍₁₋ₘ₎SrₘTiO_{y} dans lesquels y est compris entre 2,50 et 2,99, bornes incluses et m est compris entre 0 et 1, bornes incluses.

18. Composite polymère-céramique selon l'une des revendications 16 à 17, dans lequel m est compris entre 0 et 0,3, bornes incluses.

19. Composite polymère-céramique selon l'une des revendications 16 à 18, dans lequel le polymère représente de 30 à 80% en volume dudit composite.

20. Composite polymère-céramique selon l'une des revendications 16 à 19, dans lequel les grains de sous oxydes de titanate de baryum/strontium représentent ensemble de 30 à 70% en volume dudit composite.

21. Composite polymère-céramique selon l'une des revendications 16 à 20, dans lequel le polymère et les sous oxydes de titanate de baryum/strontium représentent ensemble plus de 70% du poids total du composite et de préférence plus de 90% du poids du composite.

## Patentansprüche

1. Element für die Elektronik, umfassend einen oder bestehend aus einem Polymer-Keramik-Verbundstoff, umfassend Titansuboxid-Teilchen mit der allgemeinen Formel TiOₓ, wobei x zwischen 1,00 und 1,99 liegt, Grenzen eingeschlossen, und/oder Barium- und/oder Strontiumtitanatsuboxid-Teilchen mit der allgemeinen Formel Ba₍₁₋ₘ₎SrₘTiO_{y}, wobei y zwischen 1,50 und 2,99 liegt, Grenzen eingeschlossen, und m zwischen 0 und 1 liegt, Grenzen eingeschlossen.

2. Element für die Elektronik nach dem vorhergehenden Anspruch, wobei der Polymer-Keramik-Verbundstoff mehr als 10 Vol% Titansuboxid-Teilchen mit der allgemeinen Formel TiOₓ umfasst, wobei x zwischen 1,50 und 1,99 liegt, Grenzen eingeschlossen.

3. Element für die Elektronik nach einem der vorhergehenden Ansprüche, wobei die Titansuboxide hauptsächlich TiₙO₂ₙ₋₁-Phasen sind, wobei n zwischen 4 und 9 liegt, Grenzen eingeschlossen, das heißt Ti₄O₇, Ti₅O₉, Ti₆O₁₁, Ti₇O₁₃, Ti₈O₁₅ oder Ti₉O₁₇, wobei die Phasen insgesamt mehr als 80 % des Gewichts der Teilchen darstellen.

4. Element für die Elektronik nach einem der vorhergehenden Ansprüche, wobei der Polymer-Keramik-Verbundstoff mehr als 10 Vol% Barium-/Strontiumtitanatsuboxid-Teilchen mit der allgemeinen Formel Ba₍₁₋ₘ)SrₘTiO_{y} umfasst, wobei y zwischen 2,50 und 2,99 liegt, Grenzen eingeschlossen, und m zwischen 0 und 1 liegt, Grenzen eingeschlossen.

5. Element für die Elektronik nach dem vorhergehenden Anspruch, wobei m zwischen 0 und 0,3 liegt, Grenzen eingeschlossen.

6. Element für die Elektronik nach einem der vorhergehenden Ansprüche, wobei das Polymer 30 bis 80 Vol% des Polymer-Keramik-Verbundstoffs darstellt.

7. Element für die Elektronik nach einem der vorhergehenden Ansprüche, wobei das Polymer des Polymer-Keramik-Verbundstoffs ausgewählt ist aus der Gruppe, bestehend aus den Epoxidharzen, Polyvinylidenfluorid (PVDF), Polytetrafluorethylen (PTFE), Polyimiden, Polyamiden, Acrylaten, Polyphenylenether, Polyphenylenoxid, Benzocyclobuten, Bismaleimid, Cyanatester, Polyester und ihren Gemischen.

8. Element für die Elektronik nach einem der vorhergehenden Ansprüche, wobei das Polymer des Polymer-Keramik-Verbundstoffs aus den wärmehärtbaren Harzen ausgewählt ist.

9. Element für die Elektronik nach einem der vorhergehenden Ansprüche, wobei das Polymer des Polymer-Keramik-Verbundstoffs aus den thermoplastischen Harzen ausgewählt ist.

10. Element für die Elektronik nach einem der vorhergehenden Ansprüche, wobei die Titansuboxid-Teilchen und/oder die Barium-/Strontiumtitanatsuboxid-Teilchen zusammen 30 bis 70 Vol% des Polymer-Keramik-Verbundstoffs darstellen.

11. Element für die Elektronik nach einem der vorhergehenden Ansprüche, wobei das Polymer, die Titansuboxide und die Barium-/Strontiumtitanatsuboxide zusammen mehr als 70 % des Gesamtgewichts des Polymer-Keramik-Verbundstoffs und vorzugsweise mehr als 90 % des Gewichts des Verbundstoffs darstellen.

12. Element für die Elektronik nach einem der vorhergehenden Ansprüche, wobei der mineralische Füllstoff in dem Polymer-Keramik-Verbundstoff im Wesentlichen aus Titansuboxid-Teilchen besteht.

13. Element für die Elektronik nach einem der vorhergehenden Ansprüche, wobei der mineralische Füllstoff in dem Polymer-Keramik-Verbundstoff im Wesentlichen aus Barium- und/oder Strontiumtitanatsuboxid-Teilchen mit der allgemeinen Formel Ba₍₁₋ₘ₎SrₘTiO_{y} besteht.

14. Element für die Elektronik nach einem der vorhergehenden Ansprüche, wobei die Komponente ein Kondensator, vorzugsweise ein integrierter Kondensator, ist.

15. Element für die Elektronik nach einem der Ansprüche 1 bis 13, wobei die Komponente ein Schirm zur Abschwächung der elektromagnetischen Wellen ist.

16. Polymer-Keramik-Verbundstoff, umfassend Barium- und/oder Strontiumtitanatsuboxid-Teilchen mit der allgemeinen Formel Ba₍₁₋ₘ₎SrₘTiO_{y}, wobei y zwischen 1,50 und 2,99 liegt, Grenzen eingeschlossen, und m zwischen 0 und 1 liegt, Grenzen eingeschlossen.

17. Polymer-Keramik-Verbundstoff nach dem vorhergehenden Anspruch, umfassend mehr als 10 Vol% Barium-/Strontiumtitanatsuboxid-Teilchen mit der allgemeinen Formel Ba₍₁₋ₘ₎SrₘTiO_{y}, wobei y zwischen 2,50 und 2,99 liegt, Grenzen eingeschlossen, und m zwischen 0 und 1 liegt, Grenzen eingeschlossen.

18. Polymer-Keramik-Verbundstoff nach einem der Ansprüche 16 bis 17, wobei m zwischen 0 und 0,3 liegt, Grenzen eingeschlossen.

19. Polymer-Keramik-Verbundstoff nach einem der Ansprüche 16 bis 18, wobei das Polymer 30 bis 80 Vol% des Verbundstoffs darstellt.

20. Polymer-Keramik-Verbundstoff nach einem der Ansprüche 16 bis 19, wobei die Barium-/Strontiumtitanatsuboxid-Teilchen zusammen 30 bis 70 Vol% des Verbundstoffs darstellen.

21. Polymer-Keramik-Verbundstoff nach einem der Ansprüche 16 bis 20, wobei das Polymer und die Barium-/Strontiumtitanatsuboxid-Teilchen zusammen mehr als 70 % des Gesamtgewichts des Verbundstoffs und vorzugsweise mehr als 90 % des Gewichts des Verbundstoffs darstellen.

## Claims

1. An element for electronics comprising or consisting of a polymer-ceramic composite comprising grains of titanium suboxides of general formulation TiOₓ in which x is between 1.00 and 1.99, limits included, and/or grains of barium and/or strontium titanate suboxides of general formulation Ba₍₁₋ₘ₎SrₘTiO_{y} in which y is between 1.50 and 2.99, limits included, and m is between 0 and 1, limits included.

2. The element for electronics as claimed in the preceding claim, in which the polymer-ceramic composite comprises more than 10% by volume of grains of titanium suboxides of general formulation TiOₓ in which x is between 1.50 and 1.99, limits included.

3. The element for electronics as claimed in either of the preceding claims, in which said titanium suboxides are mainly TiₙO₂ₙ₋₁ phases in which n is between 4 and 9, limits included, that is to say Ti₄O₇, Ti₅O₉, Ti₆O₁₁, Ti₇O₁₃, Ti₈O₁₅ or Ti₉O₁₇, said phases representing, in total, more than 80% of the weight of the grains.

4. The element for electronics as claimed in one of the preceding claims, in which the polymer-ceramic composite comprises more than 10% by volume of grains of barium/strontium titanate suboxides of general formulation Ba₍₁₋ₘ₎SrₘTiO_{y} in which y is between 2.50 and 2.99, limits included, and m is between 0 and 1, limits included.

5. The element for electronics as claimed in the preceding claim, in which m is between 0 and 0.3, limits included.

6. The element for electronics as claimed in one of the preceding claims, in which the polymer represents from 30 to 80% by volume of said polymer-ceramic composite.

7. The element for electronics as claimed in one of the preceding claims, in which the polymer of the polymer-ceramic composite is chosen from the group consisting of epoxy, polyvinylidene fluoride (PVDF), polytetrafluoroethylene (PTFE), polyimide, polyamide, acrylate, polyphenylene ether, polyphenylene oxide, benzocyclobutene, bismaleimide, cyanate ester or polyester resins or their mixtures.

8. The element for electronics as claimed in one of the preceding claims, in which the polymer of the polymer-ceramic composite is chosen from thermosetting resins.

9. The element for electronics as claimed in one of the preceding claims, in which the polymer of the polymer-ceramic composite is chosen from thermoplastic resins.

10. The element for electronics as claimed in one of the preceding claims, in which the grains of titanium suboxides and/or the grains of barium/strontium titanate suboxides together represent from 30 to 70% by volume of said polymer-ceramic composite.

11. The element for electronics as claimed in one of the preceding claims, in which the polymer, the titanium suboxides and the barium/strontium titanate suboxides together represent more than 70% of the total weight of the polymer-ceramic composite and preferably more than 90% of the weight of the composite.

12. The element for electronics as claimed in one of the preceding claims, in which the inorganic charge in said polymer-ceramic composite is essentially composed of grains of titanium suboxides.

13. The element for electronics as claimed in one of the preceding claims, in which the inorganic charge in said polymer-ceramic composite is essentially composed of grains of barium and/or strontium titanate suboxides of general formulation Ba₍₁₋ₘ₎SrₘTiO_{y}.

14. The element for electronics as claimed in one of the preceding claims, in which said component is a capacitor, preferably an embedded capacitor.

15. The element for electronics as claimed in one of claims 1 to 13, in which said component said element is a shield for attenuation of electromagnetic waves.

16. A polymer-ceramic composite comprising grains of barium and/or strontium titanate suboxides of general formulation Ba₍₁₋ₘ)SrₘTiO_{y} in which y is between 1.50 and 2.99, limits included, and m is between 0 and 1, limits included.

17. The polymer-ceramic composite as claimed in the preceding claim, comprising more than 10% by volume of grains of barium/strontium titanate suboxides of general formulation Ba₍₁₋ₘ₎SrₘTiO_{y} in which y is between 2.50 and 2.99, limits included, and m is between 0 and 1, limits included.

18. The polymer-ceramic composite as claimed in either of claims 16 and 17, in which m is between 0 and 0.3, limits included.

19. The polymer-ceramic composite as claimed in one of claims 16 to 18, in which the polymer represents from 30 to 80% by volume of said composite.

20. The polymer-ceramic composite as claimed in one of claims 16 to 19, in which the grains of barium/strontium titanate suboxides together represent from 30 to 70% by volume of said composite.

21. The polymer-ceramic composite as claimed in one of claims 16 to 20, in which the polymer and the barium/strontium titanate suboxides together represent more than 70% of the total weight of the composite and preferably more than 90% of the weight of the composite.
